# EUROPÄISCHE PATENTANMELDUNG

(11) **EP 3 633 741 A1**
(43) Veröffentlichungstag der Anmeldung: **08.04.2020**
(21) Anmeldenummer: 19197536.6
(22) Anmeldetag: 16.09.2019
(51) Int. Cl.: H01L 31/18, H01L 31/072, H01L 31/0747, H01L 31/068, H01L 21/223

(54) **VERFAHREN ZUR HERSTELLUNG EINER PHOTOVOLTAISCHEN SOLARZELLE MIT EINEM HETEROÜBERGANG UND EINEM EINDIFFUNDIERTEM EMITTERBEREICH**

(30) Priorität: 24.09.2018 DE 102018123397
(71) Anmelder: FRAUNHOFER-GESELLSCHAFT zur Förderung der angewandten Forschung e.V., 80686 München (DE)
(72) Erfinder: HERMLE, Martin, 79110 Freiburg (DE); JANZ, Stefan, 79110 Freiburg (DE)
(74) Vertreter: Lemcke, Brommer & Partner Patentanwälte Partnerschaft mbB

(57) **Zusammenfassung**

Die Erfindung betrifft ein Verfahren zur Herstellung einer photovoltaischen Solarzelle mit mindestens einem eindiffundierten Diffusionsbereich und mindestens einem Heteroübergang, mit den Verfahrensschritten
A. Bereitstellen mindestens eines Halbleitersubstrats (1) mit einer Basisdotierung;
B. Erzeugen des Heteroübergangs an einer Rückseite des Halbleitersubstrats, welcher Heteroübergang mit einer dotierten, siliziumhaltigen Heteroübergangsschicht (5) und einer mittelbar oder unmittelbar zwischen Heteroübergangsschicht und Halbleitersubstrat angeordneten dielektrischen Tunnelschicht (4) ausgebildet wird,
C. Texturieren (3) der Oberfläche des Halbleitersubstrats zumindest an einer der Rückseite gegenüberliegenden Vorderseite des Halbleitersubstrats;
D. Erzeugen des Diffusionsbereiches (2) an der Vorderseite des Halbleitersubstrats durch Eindiffundieren zumindest eines Diffusions-Dotierstoffes mit einem der Basisdotierung entgegengesetzten Dotierungstyp in das Halbleitersubstrat;

Die Erfindung ist dadurch gekennzeichnet, dass die vorgenannten Verfahrensschritte - mit oder ohne Zwischenschaltung weiterer Verfahrensschritte - in der Reihenfolge A-C-B-D durchgeführt werden, dass in Verfahrensschritt D der Diffusionsbereich mittels Diffusion aus der Gasphase bei einer Temperatur im Bereich 700°C bis 1200°C in einer sauerstoffarmen Atmosphäre bei Zufuhr eines den Dotierstoff enthaltenden Dotier-Gasgemisches erzeugt wird, dass nach Verfahrensschritt D - mit oder ohne Zwischenschaltung weiterer Verfahrensschritte - zumindest in einem Verfahrensschritt D1 eine Temperaturbehandlung bei einer Temperatur im Bereich 700°C bis 1200°C ohne Zufuhr des Dotier-Gasgemisches erfolgt, um den Diffusions-Dotierstoff in das Halbleitersubstrat einzutreiben und um die dotierte Heteroübergangsschicht zu aktivieren und dass Verfahrensschritte D und D1 in-situ durchgeführt und währenddessen die Rückseite des Halbleitersubstrates durch ein diffusionshemmendes Element geschützt wird, welches nicht Bestandteil der Solarzelle ist.

## Beschreibung

Die Erfindung betrifft ein Verfahren zur Herstellung einer photovoltaischen Solarzelle mit mindestens einem eindiffundierten Emitterbereich und mindestens einem Heteroübergang gemäß Oberbegriff des Anspruchs 1.

Eine photovoltaische Solarzelle stellt ein flächiges Halbleiterbauelement dar, bei welchem durch Absorption einfallender elektromagnetischer Strahlung Ladungsträgerpaare erzeugt und anschließend an einem pn-Übergang getrennt werden, so dass zwischen mindestens zwei elektrischen Kontaktpunkten der Solarzelle ein Potential entsteht und elektrische Leistung abgegriffen werden kann.

Der pn-Übergang kann dadurch realisiert sein, dass in einem Halbleitersubstrat mit einer Basisdotierung mittels Diffusion eines Dotierstoffes einer zu der Basisdotierung entgegengesetzten Emitterdotierung ein entsprechender Emitterbereich ausgebildet wird, so dass zwischen Emitterbereich und basisdotiertem Bereich des Halbleitersubstrates ein pn-Übergang entsteht.

Ebenso ist es bekannt, den Emitter durch Aufbringen einer oder mehrerer Schichten auf ein Basissubstrat auszubilden, insbesondere durch Aufbringen einer Emitterschicht aus amorphem Silizium auf einem Basissubstrat bestehend aus monokristallinem Silizium. Die Emitterschicht weist auch hier einen zu der Basis entgegengesetzten Dotierungstyp auf (Dotierungstypen sind der n-Dotierungstyp und der hierzu entgegengesetzte p-Dotierungstyp), so dass sich zwischen Emitter und Basis ein pn-Übergang ausbildet. Da die amorphe Siliziumschicht des Emitters gegenüber dem kristallinen Silizium der Basis eine unterschiedliche Bandlücke aufweist, bildet sich ein so genannter Hetero-pn-Übergang aus, so dass ein so genannter Heteroemitter vorliegt.

Sofern Basissubstrat und amorphe Siliziumschicht den gleichen Dotierungstyp, jedoch unterschiedliche Dotierkonzentrationen aufweisen, entsteht ebenfalls ein Heteroübergang, in diesem Fall eine sogenannte "High-Low-Junction". Solche Heteroübergänge werden zur Ausbildung von Heterokontakten verwendet:
Auch bei der Kontaktierung der Halbleiterbereiche sind unterschiedliche physikalische Kontaktarten bekannt: Typischerweise wird eine metallische Kontaktierungsstruktur mittelbar oder unmittelbar auf den zu kontaktierenden Halbleiterbereich aufgebracht. Hierbei ist insbesondere die Ausbildung eines Ohmschen Kontaktes und eines Schottky-Kontaktes bekannt. Ebenfalls als spezielle Ausbildung eines Hetero-Kontaktes sind auch MOS/MIS-Kontakte bekannt. Eine spezielle Ausführung von MOS/MIS Kontakten ist folgender Aufbau, Substrat/Tunneloxid/dotierte poly-Si-Schicht. Solche Kontaktarten sind bei Halbleitern bekannt und beispielsweise beschrieben in Peter Würfel, Physics of Solar Cells: From Principles to New Concepts. 2005, Weinheim: Wiley-VCH. (HeteroKontakt: Kapitel 6.6, S. 127ff; Schottky-Kontakt: Kapitel 6.7.1, S. 131f; MIS-Kontakt: Kapitel 6.7.2, S.132) und Sze, S.M., Semiconductor devices: Physics and Technology. 1985, New York: John Wiley & sons. (MOS-Kontakt: Kapitel 5.4, S.186; Metall-Halbleiterkontakt: Kapitel 5.1, S. 160ff.).

Heteroübergänge werden klassischerweise als Übergänge von Materialien unterschiedlicher Bandlücke bezeichnet. Heterokontakte können aber auch unter Anordnung einer Tunnelschicht zwischen Halbleitersubstrat und Heteroübergangsschicht ausgebildet sein, beispielsweise als Substrat/Tunneloxid/siliziumhaltige Schicht bzw. MIS-Kontakte wie zuvor beschrieben. Die Bezeichnung "Heteroübergang" wird in dieser Anmeldung in diesem umfassenden Sinn verwendet. Die "Hetero"-Eigenschaft des Heteroübergangs kann somit in einer unterschiedlichen Bandlücke zwischen Halbleitersubstrat und Heteroübergangsschicht und/oder zwischen Tunnelschicht und Heteroübergangsschicht begründet sein.

Die Bezeichnung "Heteroübergang" umfasst in dieser Anmeldung wie eingangs bereits erwähnt sowohl Übergänge mit Schichten unterschiedlicher Dotierungstypen, insbesondere zur Ausbildung von Heteroemittern, als auch Übergänge mit Schichten gleicher Dotierungstypen, insbesondere zur Ausbildung von Heterokontakten.

Analog zu der hinsichtlich der Emitter eingeführten Definition werden vorliegend solche Kontakte, die keine Heterokontakte sind, als Homokontakte bezeichnet.

Es besteht ein Bedarf an Herstellungsverfahren für Solarzellen, welche diffundierte Dotierbereiche mit Heteroübergängen kombinieren. Dies kann beispielsweise die Kombination eines Hetero-pn-Übergangs mit einem Basishochdotierungsbereich, d. h. einem gegenüber der Basisdotierung höher dotierten Bereich des Basisdotierungstyps (auch bei Anordnung an der Rückseite "BSF", Back Surface Field" und bei Anordnung an der Vorderseite "FSF", Front Surface Field genannt) sein. Ebenso kann dies die Kombination eines Heterokontaktes mit einem mittels Diffusion eines Dotierstoffes erzeugten Homoemitters und unter entsprechender Ausbildung eines Homo-pn-Übergangs sein.

Eine Solarzelle, welche diffundierte Bereiche und Heteroübergänge aufweist, ist aus DE 10 2013 219 564 A1 bekannt.

Der vorliegenden Erfindung liegt die Aufgabe zugrunde, das vorbekannte Verfahren hinsichtlich der Kosteneffizienz und des Potentials für hohe Wirkungsgrade der hergestellten photovoltaischen Solarzelle zu verbessern.

Gelöst ist diese Aufgabe durch ein Verfahren gemäß Anspruch 1. Vorteilhafte Ausgestaltungen finden sich in den abhängigen Ansprüchen.

Das erfindungsgemäße Verfahren zur Herstellung einer photovoltaischen Solarzelle mit mindestens einem eindiffundierten Diffusionsbereich und mindestens einem Heteroübergang weist folgende Verfahrensschritte auf:
In einem Verfahrensschritt A erfolgt ein Bereitstellen mindestens eines Halbleitersubstrates mit einer Basisdotierung. In einem Verfahrensschritt B erfolgt ein Erzeugen des Heteroübergangs an einer Rückseite des Halbleitersubstrats. Der Heteroübergang wird mit einer dotierten, siliziumhaltigen Heteroübergangsschicht und einer mittelbar oder unmittelbar zwischen Heteroübergangsschicht und Halbleitersubstrat angeordneten dielektrischen Tunnelschicht ausgebildet. In einem Verfahrensschritt C erfolgt ein Texturieren der Oberfläche des Halbleitersubstrates zumindest an einer der Rückseite gegenüberliegenden Vorderseite des Halbleitersubstrates. In einem Verfahrensschritt D erfolgt ein Erzeugen des Diffusionsbereichs an der Vorderseite des Halbleitersubstrats durch Eindiffundieren zumindest eines Diffusions-Dotierstoffes mit einem dem Dotierungstyp der Heteroübergangsschicht entgegengesetzten Dotierungstyp in das Halbleitersubstrat.

Wesentlich ist, dass die vorgenannten Verfahrensschritte in der Reihenfolge A-C-B-D durchgeführt werden. Hierbei liegt es im Rahmen der Erfindung, dass zwischen den genannten Verfahrensschritten weitere Verfahrensschritte zwischengeschaltet werden oder keine weiteren Verfahrensschritte zwischengeschaltet werden.

Weiterhin wird in Verfahrensschritt D der Diffusionsbereich mittels Diffusion aus der Gasphase bei einer Temperatur im Bereich 700°C bis 1.200°C in einer sauerstoffarmen Atmosphäre bei Zufuhr eines dem Dotierstoff enthaltenden Dotier-Gasgemisches erzeugt.

Nach Verfahrensschritt D - mit oder ohne Zwischenschaltung weiterer Verfahrensschritte - erfolgt zumindest in einem Verfahrensschritt D1 eine Temperaturbehandlung bei einer Temperatur im Bereich 700°C bis 1200°C ohne Zufuhr des Dotier-Gasgemisches, um den Diffusions-Dotierstoff in das Halbleitersubstrat einzutreiben und, um die dotierte Heteroübergangsschicht zu aktivieren.

Die Verfahrensschritte D und D1 werden in-situ durchgeführt und währenddessen wird die Rückseite des Halbleitersubstrates durch ein diffusionshemmendes Element geschützt, welches nicht Bestandteil der Solarzelle ist.

Die Erfindung ist in der Erkenntnis begründet, dass photovoltaische Solarzellen mit diffundiertem Diffusionsbereich, insbesondere diffundiertem Emitter, insbesondere auf siliziumbasierenden Solarzellen meist durch die Rekombination am Metall-Halbleiterkontakt limitiert sind, da hierdurch die Offenklemmspannung signifikant reduziert werden kann. Es besteht daher Bedarf, ein Verfahren zur Herstellung einer photovoltaischen Solarzelle zur Verfügung zu stellen, bei welchem eine Steigerung des Wirkungsgrades durch Verringerung der Rekombination am Metall-Halbleiterkontakt sowie durch Optimierung des Dotierprofils, insbesondere eines Emitterprofils möglich ist. Gleichzeitig soll dieses Verfahren kostengünstig ausgestaltet sein, damit eine erzielte Erhöhung des Wirkungsgrades nicht durch erhöhte Herstellungskosten kompensiert wird.

Das Verfahren gemäß der vorliegenden Erfindung bietet nun die Möglichkeit, rückseitig mittels des Heteroübergangs einen Heterokontakt auszubilden, so dass die vorgenannten Verluste bei der Offenklemmspannung erheblich reduziert werden. Weiterhin wird durch Erzeugen des Diffusionsbereichs aus der Gasphase in einer sauerstoffarmen Atmosphäre das an sich übliche Ausbilden eines Dotierglases verhindert. Im Gegensatz zu üblichen Verfahren zum Erzeugen eines eindiffundierten Emitters wird somit kein Dotierglas als Dotierstoffquelle verwendet, welches eine so genannte "unendliche Dotierstoffquelle" unter üblichen Prozessbedingungen darstellt. Hierdurch wird einerseits der Vorteil erzielt, dass ein präziseres Ausbilden des Dotierprofils des Diffusionsbereichs, insbesondere eines Emitterprofils möglich ist:
Die Menge des für den Dotiervorgang bei Erzeugen des Diffusionsbereichs zur Verfügung stehenden Dotierstoffes kann bei dem vorliegenden Verfahren durch die Menge bzw. Konzentration des Dotierstoffes im Dotier-Gasgemisch vorgegeben werden. Insbesondere kann in Verfahrensschritt D1 ein Eintreiben des Dotierstoffes erfolgen, ohne oder zumindest mit erheblich geringerer Zufuhr von neuem Dotierstoff in das Halbleitersubstrat, da in Verfahrensschritt D1 keine Zufuhr des Dotier-Gasgemisches erfolgt. Es lassen sich somit wesentlich präziser gewünschte Dotierprofile erzeugen, um den Wirkungsgrad zu erhöhen.

Darüber hinaus ist bei dem vorliegenden Verfahren kein Abätzen eines Dotierglases notwendig, da - wie bereits zuvor beschrieben - aufgrund der sauerstoffarmen Atmosphäre die Ausbildung eines solchen Glases vermieden wird. Dies ermöglicht jedoch weiterhin das Durchführen zumindest der Verfahrensschritte D und D1 in-situ, wobei die Rückseite des Halbleitersubstrates (und somit der Heteroübergang) durch ein diffusionshemmendes Element geschützt wird, welches nicht Bestandteil der Solarzelle ist. In unaufwändiger und somit kostensparender Weise wird somit das Erzeugen einer hocheffizienten Solarzellenstruktur ermöglicht, wobei insbesondere für die Verfahrensschritte D und D1 es nicht notwendig ist, rückseitig eine Diffusionsbarrierenschicht auf die Solarzelle aufzubringen und auch nicht, dass Halbleitersubstrat zwischen diesen Prozessschritten aus einer Prozesskammer auszuschleusen.

Das erfindungsgemäße Verfahren ist weiterhin dadurch kostensparend ausgebildet, dass in Verfahrensschritt D1 gleichzeitig der Diffusions-Dotierstoff in das Halbleitersubstrat eingetrieben wird und die dotierte Heteroübergangsschicht aktiviert wird.

Entsprechend erfolgt bei dem erfindungsgemäßen Verfahren im Gegensatz zu dem typischen Vorgehen bei vorbekannten Verfahren ein Texturieren der Oberfläche gemäß Verfahrensschritt C vor Erzeugen des Heteroübergangs gemäß Verfahrensschritt B.

Das erfindungsgemäße Verfahren ermöglicht somit das Herstellen einer Solarzellenstruktur für höchste Wirkungsgrade ohne das zusätzliche, kostenintensive Prozessschritte notwendig sind bzw. diese durch Einsparen zusätzlicher Schritte gegenüber vorbekannten Verfahren kompensiert werden.

Die vorliegende Erfindung zeichnet sich somit dadurch aus, dass ein Diffusionsbereich direkt aus der Gasphase realisiert wird, ohne dass sich ein Dotierglas bildet, dass hierdurch eine Modifikation des Dotiervorgangs aus der Gasphase durch Verändern des Dotier-Gasgemisches, insbesondere der Dotierstoffkonzentration im Dotier-Gasgemisch möglich ist sowie ein Eintreiben des Dotierstoffes ohne Zufuhr von Dotier-Gasgemisch und dass während des Eintreibens gleichzeitig die dotierte Heteroübergangsschicht aktiviert wird.

Es ergeben sich somit insbesondere die Vorteile, dass der Diffusionsbereich eindiffundiert wird, ohne dass ein Abätzen eines Dotierglases notwendig ist. Durch Verwenden eines diffusionshemmenden Elementes, welches nicht Bestandteil der Solarzelle ist, ist keine Schutzschicht an der Rückseite der Solarzelle während des Erzeugens des Diffusionsbereichs notwendig. Durch die zusätzlichen Freiheitsgrade bei Erzeugen des Diffusionsbereichs aufgrund der Veränderung des Dotier-Gasgemisches und des Eintreibens ohne Zufuhr von Dotier-Gasgemisch kann ein optimales Dotierprofil des Diffusionsbereichs erzielt werden. Durch Aktivierung der Heteroübergangsschicht in Verfahrensschritt D1 kann eine optimale Aktivierung durchgeführt werden, ohne dass hierbei unerwünschte Dotierungen des Diffusionsbereichs auftreten.

Das erfindungsgemäße Verfahren ermöglicht somit einen sehr einfachen und schlanken Prozessfluss, der im Gegensatz zu typischen vorbekannten Verfahren keine rückseitige Schutzschicht während der Diffusion des Diffusionsbereichs benötigt, keine hochprozentige Flusssäure zum Abnehmen eines Dotierglases benötigt und gleichzeitig ein optimales Dotierprofil und eine optimale Aktivierung der Heteroübergangsschicht ermöglicht.

Das Erzeugen des Diffusionsbereiches erfolgt somit bevorzugt ohne Ausbilden einer den Diffusions-Dotierstoff enthaltenen Glasschicht, so dass auch eine Entfernung derselben nicht notwendig ist.

Wie zuvor beschrieben, wird während der Verfahrensschritte D und D1 die Rückseite des Halbleitersubstrates durch ein diffusionshemmendes Element geschützt, welches nicht Bestandteil der Solarzelle ist. Vorteilhafterweise ist daher in den Verfahrensschritten D und D1 an der Rückseite der Solarzelle und bevorzugt an der Vorderseite der Solarzelle keine diffusionshemmende Schicht angeordnet. Hierdurch wird der Prozess vereinfacht und somit kostengünstiger.

Die in Verfahrensschritt B erzeugte Tunnelschicht ist als dielektrische Tunnelschicht zur Ausbildung eines an sich bekannten Heteroübergangs ausgebildet. Untersuchungen zeigen, dass der Ladungstransport über ein solcher Heteroübergang über den Mechanismus des Tunnelns erzielt wird. Ebenso scheint nach aktuellem Forschungsstand ein Ladungstransport über eine Mehrzahl kleiner Öffnungen möglich, so genannter "Pinholes". Im Sinne dieser Anmeldung bezeichnet die dielektrische Tunnelschicht somit jegliche dielektrische Schicht, welche zur Ausbildung eines Heteroübergangs geeignet ist.

Vorteilhafterweise wird die dielektrische Tunnelschicht in Verfahrensschritt B mit einer Dicke größer 0,5nm, insbesondere im Bereich 1nm bis 5nm ausgebildet. Weiterhin ist es vorteilhaft, dass in Verfahrensschritt D und/oder in Verfahrensschritt D1 eine zumdindest Teilkristiallisation der dotierten, siliziumhaltigen Heteroübergangsschicht erfolgt, und die Passivierqualiät der Tunnelschicht durch Erwärmen auf eine Temperatur größer 850°C, bevorzugt für eine Zeitdauer von zumindest 5 min, verbessert wird. Dies begünstigt das Ausbilden eines Heteroübergangs mit hoher elektronischer Güte.

Bei dickeren Tunnelschichten (>2 nm) bei denen ein Ladungstransport mittels tunneln unwahrscheinlicher wird, kann eine höhere Temperatur über 950 °C zu einem teilweisen Aufbrechen der Tunnelschicht führen und damit ein Ladungstransport durch die "Pinholes" erst möglich machen. Daher können für dickere Schichtdicken in B auch höherer Prozesstemperaturen in D verwendet werden. Die Schichtdicke in B und Prozesstemperaturen in D können daher so angepasst werden, das eine optimaler Ladungstransport und ein sehr guter Emitter gebildet werden können. Bei Prozesstemperaturen bis 900° C ist die Schichtdicke der Tunnelschicht bevorzugt kleiner gleich 1,5 nm , im Bereich 900-1100 °C der Prozesstemperaturen beträgt liegt die Schichtdicke der Tunnelschicht bevorzugt im Bereich 1,5 nm bis 3nm.

Das Dotier-Gasgemisch enthält bevorzugt den Dotierstoff und Wasserstoff. Insbesondere ist es vorteilhaft, dass das Dotier-Gasgemisch aus Dotierstoff und Wasserstoff besteht. Hierdurch wird ein effizienter Diffusionsvorgang zum Ausbilden des Diffusionsbereichs ermöglicht und gleichzeitig das Ausbilden eines Dotierglases verhindert.

Dotierstoffe sind bevorzugt Stoffe aus der III. oder V. Hauptgruppe, insbesondere bevorzugt Bor oder Phosphor.

Das Halbleitersubstrat kann als an sich bekanntes Halbleitersubstrat ausgebildet sein, insbesondere bevorzugt als Siliziumschicht, insbesondere Siliziumwafer. Ebenso liegt die Ausbildung des Halbleitsubstrats aus Germanium im Rahmen der Erfindung.

In einer vorteilhaften Ausgestaltung wird zumindest der Verfahrensschritt D, in einer Prozessatmosphäre mit weniger als 5% Sauerstoff, insbesondere weniger als 1% Sauerstoff, bevorzugt in einer sauerstofffreien Prozessatmosphäre durchgeführt, um die Ausbildung von Dotierglas zu verhindern. In einer weiter bevorzugten Ausführungsform wird in Verfahrenschritt D1 Sauerstoff wieder der Prozessatmosphäre zugefügt, da hierdurch ein Passivieroxidschicht auf dem Diffusionsbereich ausgebildet wird.

Wie zuvor beschrieben, ermöglicht das erfindungsgemäße Verfahren nicht nur in Verfahrensschritt D1 das Eintreiben des Dotierstoffes zum Ausbilden des Diffusionsbereichs ohne oder zumindest mit nur geringfügig zusätzlichem Einbringen von Dotierstoff. Weiterhin wird in einer vorteilhaften Ausführungsform während des Verfahrensschrittes D die Gaszufuhr des Dotier-Gasgemisches verändert, insbesondere abhängig von einem vorgegebenen Gaszuflussverlauf gesteuert. Hierdurch kann gezielt ein optimales Dotierprofils des Diffusionsbereichs erzeugt werden. Insbesondere ist es somit vorteilhaft, eine vorgegebene Dotierstoffkonzentration in dem Dotier-Gasgemisch während Verfahrensschritt D abhängig von einem vorgegebenen zeitlichen Verlauf der Dotierstoffkonzentration in dem Dotier-Gasgemisch zu regeln.

Zum Erzielen eines gewünschten Dotierprofils kann es vorteilhaft sein, in einer bevorzugten Ausführungsform die Verfahrensschritte D und D1 mehrfach alternierend durchzuführen. Es erfolgt somit eine Ausbildung des Diffusionsbereich mit Zufuhr des Dotier-Gasgemisches (Verfahrensschritt D), anschließend ein Eintreiben ohne Zufuhr von Dotier-Gasgemisch (Verfahrensschritt D1), erneut eine Diffusion aus der Gasphase mit Zuführen von Dotier-Gasgemisch (D) und schließlich erneut ein Eintreiben ohne Zufuhr von Dotier-Gasgemisch (D1). Ebenso liegt es im Rahmen der Erfindung, weitere Abfolgen der Verfahrensschritte D und D1 anzuschließen. Diese vorteilhafte Ausgestaltung ist insbesondere für Emitterdotierprofile vorteilhaft, die eine geringe Rekombination und trotzdem eine hohe Oberflächenkonzentration haben, damit man sie gut kontaktieren kann.

Das erfindungsgemäße Verfahren bietet die Möglichkeit, die Ausbildung des Diffusionsbereichs, insbesondere eines als Emitter ausgebildeten Diffusionsbereichs, als vorteilhafte Dotierverfahren auszugestalten:
In einer vorteilhaften Ausgestaltung des erfindungsgemäßen Verfahrens ist Verfahrensschritt D als Rapid Vapour Phase Direct Doping (RVD) ausgebildet. Hierdurch ergibt sich der zusätzliche Vorteil, dass die Prozesssequenz durch schnelles Aufheizen und Abkühlen der Si Wafer besonders kurz und damit kostengünstig sein kann. Das RVD-Verfahren ist an sich bekannt und beispielsweise in Lindekugel et al, EMITTERS GROWN BY RAPID VAPOUR-PHASE DIRE CT DOPING FOR HIGH EFFICIENCY SOLAR CELL, 31st European PV Solar Energy Conference and Exhibition, 14-18 September 2015, Hamburg, Germany beschrieben. Bevorzugt wird daher Verfahrensschritt D bei einer Prozesstemperatur im Bereich 750°C bis 1100°C durchgeführt.

Die Temperaturbehandlung in Verfahrensschritt D1 erfolgt bevorzugt für zumindest eine Minute, insbesondere für zumindest zehn Minuten. Hierdurch wird eine vollständige Aktivierung des Heteroübergangs begünstigt. Insbesondere bei Ausgestaltung des Verfahrensschritt D als RVD-Prozess ist eine Temperaturbehandlung im Bereich 5 Minuten bis 30 Minuten vorteilhaft.

Wie zuvor beschrieben, ermöglicht das erfindungsgemäße Verfahren insbesondere hohe Freiheitsgrade und eine präzise Ausbildung eines gewünschten Diffusionsprofils, insbesondere Emitterdotierprofils und der dazu passenden Rückseitenstruktur. Vorteilhafterweise erfolgt zur Ausbildung des Diffusionsbereiches daher keine Diffusion aus der Festphase einer Dotierschicht. Es wird somit bevorzugt vor und während der Ausbildung des Diffusionsbereiches, insbesondere als Emitter keine Schicht angeordnet, aus der während der Erzeugung des Diffusionsbereiches in signifikanter Menge Dotierstoff in die Halbleiterschicht eindringt und somit das Diffusionsprofil beeinflusst. Hierdurch ist sichergestellt, dass eine präzise Ausbildung des Diffusionsdotierprofils gemäß den Vorgaben erfolgt.

Die Heteroübergangsschicht ist bevorzugt als amorphe, siliziumenthaltende Schicht aufgebracht. In Verfahrensschritt D und/oder in Verfahrensschritt D1 wird die Heteroübergangsschicht bevorzugt zumindest teilweise, insbesondere bevorzugt vollständig in eine polykristalline Siliziumschicht umgewandelt. Die Aktivierung des Heteroübergangs erfolgt bevorzugt in an sich bekannter Weise, insbesondere durch Erwärmen zumindest des Halbleitersubstrates im Bereich der Heteroübergangsschicht auf zumindest 600°C, vorzugsweise für eine Zeitdauer von zumindest zehn Minuten. Dies entspricht an sich bekannten Parametern für eine Aktivierung eines solchen Heteroübergangs.

Die dielektrische Tunnelschicht kann mit einem Dotierstoff dotiert oder intrinsisch (undotiert) ausgebildet sein.

Der Diffusionsbereich wird vorteilhafterweise ausschließlich an der Vorderseite der Solarzelle ausgebildet. Bevorzugt bedeckt der Diffusionsbereich zumindest 50%, bevorzugt zumindest 90%, insbesondere bevorzugt zumindest 99% der Vorderseite des Halbleitersubstrats.

Insbesondere ist es vorteilhaft, dass der Diffusionsbereich die gesamte Vorderseite bedeckend ausgebildet wird.

In den Verfahrensschritten D und D1 ist die Rückseite des Halbleitersubstrates durch ein diffusionshemmendes Element geschützt, welches nicht Bestandteil der Solarzelle ist. Dies kann in einfacher Weise erfolgen, in dem gemäß einer vorteilhaften Ausführungsform das Halbleitersubstrat auf ein Trägersubstrat aufgelegt wird, welches sich in einer Prozesskammer befindet. Hierdurch kann in einfacher Weise in-situ die Durchführung der Verfahrensschritte D und D1 erfolgen, wobei gleichzeitig eine rückseitige Diffusion vermieden wird oder zumindest allenfalls geringfügig erfolgt.

Das diffusionshemmende Element kann als Substrathalter ausgeführt in Keramik, Quarz, Graphit, Siliciumkarbid oder Silizium als Platte oder Block ausgebildet sein.

In einer weiteren bevorzugten Ausführungsform erfolgt ein Einbringen von Wasserstoff in die Heteroübergangsschicht und/oder an die Grenzfläche zwischen Tunnelschicht und Halbleitersubstrat. Hierdurch wird die elektrische Güte insbesondere durch weiteres Senken der Oberflächenrekombinationsgeschwindigkeit erhöht.

Eine Methode um Wasserstoff in die Heteroübergangsschicht und/oder an die Grenzfläche zwischen Tunnelschicht und Halbleitersubstrat zu bringen, ist die Verwendung von RPHP, wie beispielsweise in S. Lindekugel, et al., "Plasma hydrogen passivation for crystalline silicon thin-films," in Proceedings of the 23rd European Photovoltaic Solar Energy Conference, Valencia, Spain, 2008, pp. 2232-5 beschrieben.

Alternativ kann der Wasserstoff dadurch eingebracht werden, dass eine wasserstoffhaltige Schicht mittelbar oder bevorzugt unmittelbar auf die Heteroübergangsschicht aufgebracht wird. Hierbei erfolgt bereits durch die Prozesswärme beim Aufbringen der Schicht ein Eindiffundieren von Wasserstoff. Vorteilhafterweise wird weiterhin Wasserstoff eindiffundiert, indem anschließend mittels Erwärmung, bevorzugt auf mindestens 350°C, zusätzlich Wasserstoff eingebracht wird.

In einer vorzugsweisen Ausführungsform ist die zuvor genannte wasserstoffhaltige Schicht als mikrokristalline Siliziumschicht, insbesondere als hydrogenisierte mikrokristalline Siliziumcarbidschicht (µc- SiₓC₁₋ₓ:H) ausgebildet. Hierdurch ergibt sich der Vorteil, dass diese Schicht leitfähiger und optisch transparenter als beispielsweise eine α-Si:H-Schicht ist. Insbesondere kann eine µc- SiₓC₁₋ₓ - Schicht vorteilhafterweise als transparente Kontaktierung dienen und somit an sich bekannte leitfähige transparente Elektroden, beispielsweise TCO-Schichten ersetzen.

Ebenso kann die wasserstoffhaltige Schicht als Siliziumnitridschicht, insbesondere hydrogenisierte Siliziumnitridschicht ausgebildet sein. Hierbei erfolgt vorzugsweise eine Erwärmung auf eine Temperatur im Bereich 700°C bis 900°C, jedoch lediglich für einen Zeitraum von wenigen Sekunden, insbesondere zwischen 1 Sekunde und 30 Sekunden, bevorzugt zwischen 1 Sekunde und 15 Sekunden. Hierdurch wird in besonders effizienter Weise in einem zeitunaufwändigen Verfahrensschritt Wasserstoff eindiffundiert. Aufgrund der kurzzeitigen Wärmebeaufschlagung wird eine Diffusion von Dotierstoff vermieden oder zumindest verringert.

In einer weiteren vorteilhaften Ausführungsform wird in Verfahrensschritt D ein Dotier-Gasgemisch verwendet, welches Wasserstoff enthält, um Wasserstoff in die Heteroübergangsschicht und/oder an die Grenzfläche zwischen Tunnelschicht und Halbleitersubstrat zu bringen. Hierdurch ergibt sich der Vorteil, dass in einfacher, kostengünstiger Weise Wasserstoff eingebracht wird. Insbesondere ist es vorteilhaft, dass das Dotier-Gasgemisch zumindest 80%, bevorzugt zumindest 90%, insbesondere zumindest 98% Wasserstoff enthält. Bevorzugt ist der Dotierstoff in Wasserstoffgas verdünnt.

Die vorbeschriebene Verwendung eines Dotier-Gasgemisches, welches Wasserstoff enthält, weist den weiteren Vorteil auf, dass kein späteres Einbringen von Wasserstoff mehr notwendig ist. Vorteilhafterweise erfolgt daher kein nachfolgendes Einbringen von Wasserstoff in die Heteroübergangsschicht und/oder an die Grenzfläche zwischen Tunnelschicht und Halbleitersubstrat, insbesondere erfolgt bevorzugt kein RPHP-Schritt.

In einer weiteren vorzugsweisen Ausführungsform wird auf die Heteroübergangsschicht an der dem Halbleitersubstrat abgewandten Seite mittelbar oder bevorzugt unmittelbar eine metallische Kontaktierungsschicht aufgebracht. Hierbei ist es insbesondere vorteilhaft, zuvor Wasserstoff wie vorangehend beschrieben in die Heteroübergangsschicht einzubringen und anschließend die metallische Kontaktierungsschicht aufzubringen.

Mittels des erfindungsgemäßen Verfahrens wird somit eine Solarzellenstruktur hergestellt, mit einem diffundierten Diffusionsbereich und einer rückseitigen Heteroübergangsschicht.

Bevorzugt ist das Halbleitersubstrat abgesehen von Emitterbereichen mit einem Basisdotierungstyp, bevorzugt eine n-Dotierung, dotiert.

In einer vorteilhaften Ausführungsform ist die Heteroübergangsschicht ebenfalls mit dem Basisdotierungstyp dotiert. Der Emitter ist mittels des Diffusionsbereiches ausgebildet und entsprechend mit einem dem Basisdotierungstyp entgegengesetzten Emitterdotierungstyp dotiert, bevorzugt eine p-Dotierung.

In einer weiteren vorteilhaften Ausführungsform ist der Emitter mittels der Heteroübergangsschicht ausgebildet, insbesondere Hetero-Emitter, ausgebildet und weist einen zu dem Basisdotierungstyp entgegengesetzten Dotierungstyp auf. In dieser Ausführungsform weist der Diffusionsbereiche eine Dotierung des Basisdotierungstyps auf. Der Diffusionsbereich ist in diesem Fall bevorzugt als eine die effektive Rekombination an der Seite des Diffusionsbereichs verringernde Schicht, insbesondere als sogenanntes FSF (front surface field), ausgebildet.

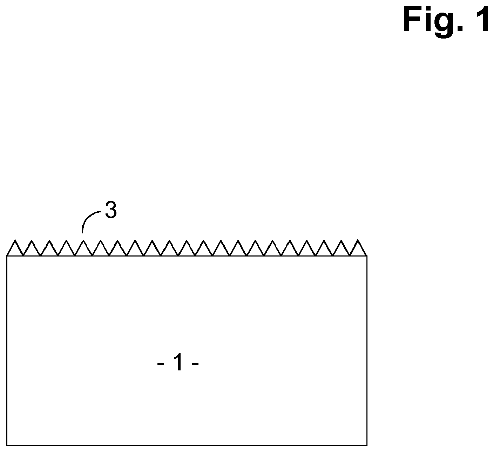

Weitere vorteilhafte Merkmale und Ausführungsformen werden im Folgenden anhand eines Ausführungsbeispiels und den Figuren erläutert. Dabei zeigen die Figuren 1 bis 5 verschiedene Ausführungsstadien eines Ausführungsbeispiels eines erfindungsgemäßen Verfahrens.

In den Figuren bezeichnen gleiche Bezugszeichen gleiche oder gleichwirkende Elemente.

In dem Ausführungsbeispiel des erfindungsgemäßen Verfahrens wird in einem Verfahrensschritt A ein als Siliziumwafer ausgebildetes Halbleitersubstrat 1 bereitgestellt. Das Halbleitersubstrat weist eine n-Dotierung mittels Phosphor mit einer Konzentration von 1x10¹⁵ cm⁻³ auf. In einem Verfahrensschritt C wurde an der Vorderseite (in den Figuren 1 bis 5 obenliegend dargestellt) eine Texturierung 3 ausgebildet. Das Halbleitersubstrat 1 ist als monokristallines Siliziumsubstrat ausgebildet, so dass in an sich bekannter Weise mittels einseitigem Ätzen an der Vorderseite eine Pyramidenstruktur (so genannte "Random Pyramids") ausgebildet werden kann. Als Ätzmedium zum Erzeugen der Pyramidenstruktur wurde vorliegend KOH verwendet.

Diese Pyramidenstruktur führt zu Mehrfachreflexionen und schrägen Einfallswinkeln, so dass insbesondere bei langwelliger Strahlung die Gesamtabsorption bei auf die Vorderseite auftreffendem Licht erhöht wird.

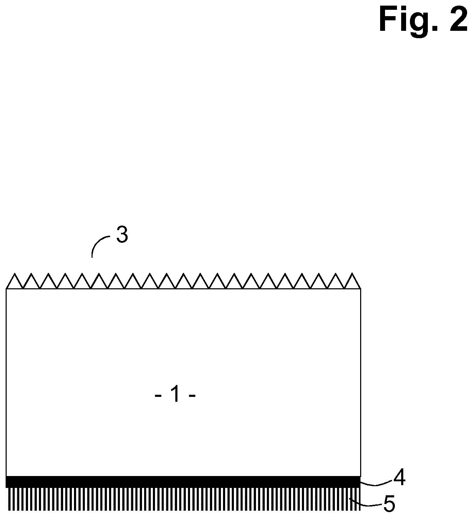

In einem Verfahrensschritt B wird an einer der Vorderseite gegenüberliegenden Rückseite des Halbleitersubstrats 1 mittels nasschemischer Oxidation eine als Siliziumdioxidschicht ausgebildete dielektrische Tunnelschicht 4 sowie eine als Silizium oder Siliciumcarbid (SiₓC₁₋ₓ)-Schicht ausgebildete Heteroübergangsschicht 5 aufgebracht. Die Tunnelschicht 4 ist somit unmittelbar zwischen Heteroübergangsschicht 5 und Halbleitersubstrat 1 angeordnet. Dieser Zustand ist in Figur 2 dargestellt.

Die Tunnelschicht 4 kann ebenso mittels einem der Verfahren PECVD, LPCVD, HPCVD, thermische Oxidation, Atomlagenabscheidung oder Trockenoxidation mit UV-Strahler aufgebracht werden. Die Siliciumhaltigen Schichten (Si, SiₓC₁₋ₓ) SiC-Schicht kann ebenso mittels einem der Verfahren PECVD (Plasma Enhanced Chemical Vapour Deposition), APCVD (Atmospheric Pressure Chemical Vapour Deposition), LPCVD (Low Pressure Chemical Vapour Deposition), HW-CVD (Hot Wire Chemical Vapour Deposition) oder Sputtern aufgebracht werden.

In einem Verfahrensschritt D wird an der Vorderseite des Halbleitersubstrats 1 ein Diffusionsbereich als Emitterbereich 2 ausgebildet, welcher die Vorderseite vollständig überdeckt. Der Emitterbereich 2 wird als p-dotierter Emitter durch Dotieren des Halbleitersubstrates 1 im Bereich der Vorderseite mit dem Dotierstoff Bor ausgebildet.

Zur Ausbildung des Emitterbereichs 2 wird das Halbleitersubstrat 1 mit der Rückseite auf ein als Keramikträger ausgebildetes diffusionshemmendes Element 8 aufgelegt und in eine Prozesskammer 7 gebracht. Anschließend wird in der Prozesskammer 7 eine nahezu sauerstofffreie Atmosphäre erzeugt, in dem Wasserstoff und Bor als Dotier-Gasgemisch in die Prozesskammer 7 eingeleitet wird und eine Erwärmung auf eine Temperatur von 1000°C für eine Zeitdauer von 30m, erfolgt. Hierdurch wird somit ein Eindiffundieren des Dotierstoffes Bor an der Vorderseite des Halbleitersubstrates 1 erzielt. Die Rückseite ist hingegen durch das diffusionshemmende Element 8 geschützt, so dass hier kein oder allenfalls geringfügig ein Eindringen von Bor erfolgt.

Aufgrund der sauerstofffreien Atmosphäre bildet sich bei dieser Eindiffusion von Bor aus der Gasphase keine Glasschicht aus.

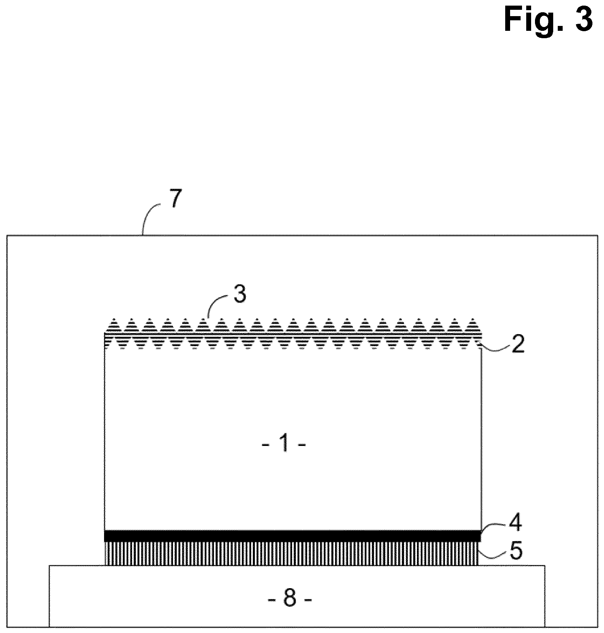

Dies ist in Figur 3 dargestellt.

Anschließend erfolgt in-situ, d. h. ohne Ausschleusen des Halbleitersubstrates aus der Prozesskammer 7, in einem Verfahrensschritt D1 eine Temperaturbehandlung bei einer Temperatur im Bereich 1.000°C für eine Minute ohne Zufuhr des Dotier-Gasgemisches. In diesem Verfahrensschritt D1 erfolgt somit keine oder allenfalls noch eine geringfügige Eindiffusion von Bor aus der Gasphase. Im Wesentlichen erfolgt während Verfahrensschritt D1 ein Eintreiben des sich bereits im Halbleitersubstrat 1 befindenden Dotierstoffs.

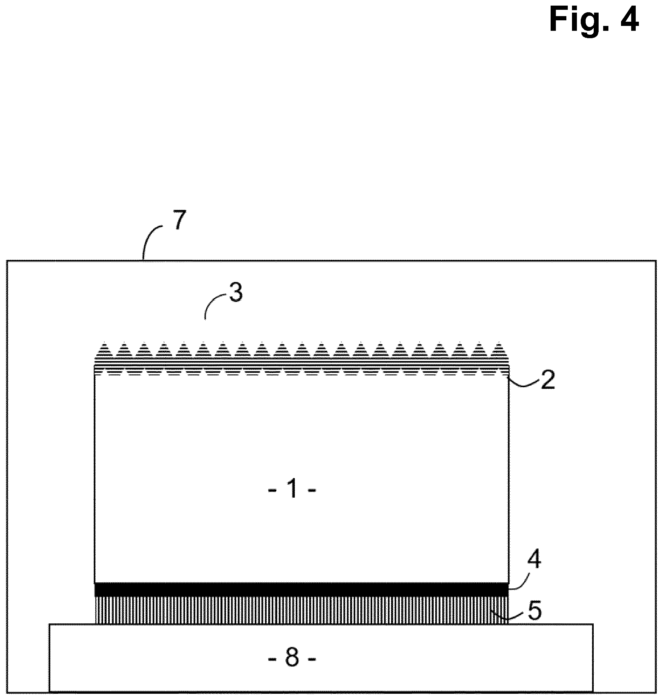

Dies ist in Figur 4 dargestellt.

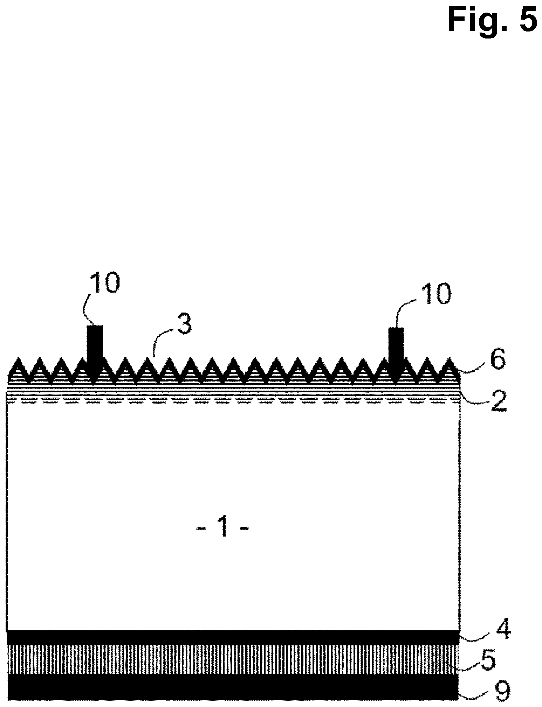

Anschließend wird rückseitig ein ganzflächiger metallischer Rückseitenkontakt 9 aufgebracht. An der Vorderseite wird zur weiteren Erhöhung der Lichtabsorption eine als Siliziumnitridschicht mit einer Dicke von 80 nm ausgebildete Antireflexschicht 6 aufgebracht. In einer Abwandlung des beschriebenen Ausführungsbeispiels wird zwischen Antireflexschicht und Halbleitersubstrat eine Passivierungsschicht angeordnet, bevorzugt eine Oxidschicht, insbesondere eine Al₂O₃-Schicht, bevorzugt mit einer Dicke im Bereich 5 bis 20 nm. Weiterhin wird an der Vorderseite in an sich bekannter Weise ein Metallisierungsgitter als metallische Vorderseitenkontaktierung 10 aufgebracht, welche die Antireflexschicht 6 durchdringt und somit den Emitterbereich 2 elektrisch kontaktiert. Dies ist in Figur 5 dargestellt.

In einer Abwandlung des beschriebenen Ausführungsbeispiels ist der Diffusionsbereich als sogenannte "Front Surface Field" (FSF) mit einer Dotierung des Basisdotierungstyps ausgebildet, insbesondere mittels Bor, und entsprechen die Heteroübergangsschicht als Hetero-Emitter mit einem zum Basisdotierungstyp entgegengesetzten Dotierungstyp, insbesondere einer Dotierung mittels Phosphor.

In der nachfolgenden Tabelle werden bevorzugte Parameterbereiche sowie unterstrichen dargestellt die in diesem Ausführungsbeispiel vorliegenden Parameter und gegebenenfalls die Herstellungsmethoden der einzelnen Schichten aufgeführt: Wie zuvor beschrieben erfolgt in einer bevorzugten Ausführungsform die Dotierung des Diffusionsbereiches als p-Typ (Emitter) und die Dotierung der Basis sowie der Heteroübergangsschicht als n-Typ. In einer weiteren bevorzugten Ausführungsform erfolgt die Dotierung des Diffusionsbereiches und der Basis als p-Typ und die Dotierung der Heteroübergangsschicht als n-Typ (Emitter).

| Schicht / Bereich (Bezugszeichen) | Material | Dicke | Dotierung [cm⁻³] |
|---|---|---|---|
| Antireflexschicht (6) | SiN, SiO₂ Al₂O₃/SiNₓ (1-20 nm/65-85nm) | 50 nm-200 nm; 10/65 nm | - |
| Homo-Diffusionsbereich: 2) | Si-Wafer (eindiffundiert) | 0.2-1.5 µm 0.3 µm | p-Typ / n-Typ (Bor/Phsophor |
| Halbleitersubstrat (1) (Basis) | Si-Wafer (Grunddotierung) | 50µm - 300µm; 200 µm | p-Typ / n-Typ (Bor/Phsophor10¹⁴-3 10¹⁶ 10¹⁵ |
| Dielektrische Tunnelschicht (4) | SiO₂ | 0.5 nm - 3 nm: 1.0 nm | - |
| Heteroübergangsschicht (5) | Si, SiₓC₁₋ₓ SiₓO₁₋ₓ | 5 nm - 100 nm: 20 nm | p-Typ / n-Typ (Bor/Phsophor10¹⁶-10²¹ 10¹⁹ |
| Rückseiten-Metallisierung: Rückseitenkontakt (9) | Ag, Al, TCO/Ag TCO/Al, TCO/Cu, TCO/Ni | 100 nm - 5µm 1µm | - |
| Vorderseiten-Metallisierung (10) | AgAl-Paste, Ag-Paste, NiCu | Höhe: 1 µm-50 µm 10 µm; Breite: 5µm - 100 µm 30 µm | |

## Patentansprüche

1. Verfahren zur Herstellung einer photovoltaischen Solarzelle mit mindestens einem eindiffundierten Diffusionsbereich (2) und mindestens einem Heteroübergang, mit den Verfahrensschritten
A. Bereitstellen mindestens eines Halbleitersubstrats mit einer Basisdotierung;
B. Erzeugen des Heteroübergangs an einer Rückseite des Halbleitersubstrats, welcher Heteroübergang mit einer dotierten, siliziumhaltigen Heteroübergangsschicht (5) und einer mittelbar oder unmittelbar zwischen Heteroübergangsschicht (5) und Halbleitersubstrat (1) angeordneten dielektrischen Tunnelschicht ausgebildet wird,
C. Texturieren der Oberfläche des Halbleitersubstrats zumindest an einer der Rückseite gegenüberliegenden Vorderseite des Halbleitersubstrats;
D. Erzeugen des Diffusionsbereiches an der Vorderseite des Halbleitersubstrats durch Eindiffundieren zumindest eines Dotierstoffes mit einem dem Dotierungstyp der Heteroübergangsschicht entgegengesetzten Dotierungstyp in das Halbleitersubstrat (1);
**dadurch gekennzeichnet,**
**dass** die vorgenannten Verfahrensschritte - mit oder ohne Zwischenschaltung weiterer Verfahrensschritte - in der Reihenfolge A-C-B-D durchgeführt werden,
**dass** in Verfahrensschritt D der Diffusionsbereich (2) mittels Diffusion aus der Gasphase bei einer Temperatur im Bereich 700°C bis 1200°C in einer sauerstoffarmen Atmosphäre bei Zufuhr eines den Dotierstoff enthaltenden Dotier-Gasgemisches erzeugt wird,
**dass** nach Verfahrensschritt D - mit oder ohne Zwischenschaltung weiterer Verfahrensschritte - zumindest in einem Verfahrensschritt D1 eine Temperaturbehandlung bei einer Temperatur im Bereich 700°C bis 1200°C ohne Zufuhr des Dotier-Gasgemisches erfolgt, um den Diffusions-Dotierstoff in das Halbleitersubstrat (1) einzutreiben und, um die dotierte Heteroübergangsschicht (5) zu aktivieren und,
**dass** Verfahrensschritte D und D1 in-situ durchgeführt und währenddessen die Rückseite des Halbleitersubstrates durch ein diffusionshemmendes Element (8) geschützt wird, welches nicht Bestandteil der Solarzelle ist.

2. Verfahren nach Anspruch 1,
**dadurch gekennzeichnet,**
**dass** das Erzeugen des Diffusionsbereiches ohne Ausbilden einer den Diffusions-Dotierstoff enthaltenden Glasschicht erfolgt.

3. Verfahren nach einem der vorangegangenen Ansprüche,
**dadurch gekennzeichnet,**
**dass** in den Verfahrensschritten D und D1 an der Rückseite der Solarzelle und bevorzugt an der Vorderseite der Solarzelle keine diffusionshemmende Schicht angeordnet ist.

4. Verfahren nach einem der vorangegangenen Ansprüche,
**dadurch gekennzeichnet,**
**dass** die dielektrische Tunnelschicht (4) in Verfahrensschritt B mit einer Dicke größer 0,5 insbesondere im Bereich 1bis 5 ausgebildet wird und dass in Verfahrensschritt D und/oder D1 eine Umwandlung der Heteroübergangschicht von einem amorphen in zumindest teilweise polymorphen Zustand erfolgt, insbesondere, dass das Tunnelloxid derart ausgestaltet ist, dass eine geringer Kontaktwiderstand entsteht.

5. Verfahren nach einem der vorangegangenen Ansprüche,
dass das Dotier-Gasgemisch den Dotierstoff und Wasserstoff enthält, insbesondere, aus dem Dotierstoff und Wasserstoff besteht.

6. Verfahren nach einem der vorangegangenen Ansprüche,
**dadurch gekennzeichnet,**
**dass** zumindest der Verfahrensschritt D in einer Prozessatmosphäre mit weniger als 5% Sauerstoff, insbesondere weniger als 1% Sauerstoff, bevorzugt in einer sauerstofffreien Prozessatmosphäre durchgeführt werden, insbesondere, dass in Verfahrensschritt D1 der Prozessatmosphäre wieder Sauerstoff zugeführt wird, um eine Oxidschicht auszubilden.

7. Verfahren nach einem der vorangegangenen Ansprüche,
**dadurch gekennzeichnet,**
**dass** während Verfahrensschritt D die Gaszufuhr des Dotier-Gasgemisches verändert wird, insbesondere abhängig von einem vorgegebenen Gaszuflussverlauf gesteuert wird.

8. Verfahren nach einem der vorangegangenen Ansprüche,
**dadurch gekennzeichnet,**
**dass** die Verfahrensschritte D und D1 mehrfach alternierend durchgeführt werden.

9. Verfahren nach einem der vorangegangenen Ansprüche,
**dadurch gekennzeichnet,**
**dass** Verfahrensschritt D als rapid vapour-phase direct doping (RVD) ausgebildet ist.

10. Verfahren nach einem der vorangegangenen Ansprüche,
**dadurch gekennzeichnet,**
**dass** die Temperaturbehandlung in Verfahrensschritt D1 für zumindest 1 min. insbesondere zumindest 10 min. erfolgt.

11. Verfahren nach einem der vorangegangenen Ansprüche,
**dadurch gekennzeichnet,**
**dass** zur Ausbildung des Diffusionsbereiches keine Diffusion aus der Festphase einer Dotierschicht erfolgt.

12. Verfahren nach einem der vorangegangenen Ansprüche,
**dadurch gekennzeichnet,**
**dass** die Heteroübergangsschicht (5) als amorphe, Silizium enthaltende Schicht aufgebracht und in Verfahrensschritt D und/oder D1 zumindest teilweise, bevorzugt vollständig in eine polykristalline Siliziumschicht umgewandelt wird.

13. Verfahren nach einem der vorangegangenen Ansprüche,
**dadurch gekennzeichnet,**
**dass** der Diffusionsbereich (2) zumindest 90% der Vorderseite bedeckend, insbesondere die gesamte Vorderseite bedeckend ausgebildet wird, insbesondere, dass der Diffusionsbereich als Emitter oder als front surface field ausgebildet wird.

14. Verfahren nach einem der vorangegangenen Ansprüche,
**dadurch gekennzeichnet,**
**dass** in Verfahrensschritt D ein Dotier-Gasgemisch verwendet wird, welches Wasserstoff enthält, insbesondere, dass das Dotier-Gasgemisch zumindest 80%, bevorzugt zumindest 90%, insbesondere zumindest 98% Wasserstoff enthält.
